Europäisches Patentamt

European Patent Office

Office européen des brevets

(11) Publication number: **0 311 674**
**B1**

## (12) EUROPEAN PATENT SPECIFICATION

(45) Date of publication of patent specification: **27.12.90**

(21) Application number: **88904098.6**

(22) Date of filing: **18.04.88**

(86) International application number:
**PCT/US88/01206**

(87) International publication number:
**WO 88/08615 03.11.88 Gazette 88/24**

(51) Int. Cl.⁵: **H 01 L 25/04**

(54) CAVITY-UP-CAVITY-DOWN MULTICHIP INTEGRATED CIRCUIT PACKAGE.

(30) Priority: **24.04.87 US 41984**

(43) Date of publication of application:
**19.04.89 Bulletin 89/16**

(45) Publication of the grant of the patent:
**27.12.90 Bulletin 90/52**

(84) Designated Contracting States:
**AT BE CH DE FR GB IT LI LU NL SE**

(56) References cited:
**FR-A-2 295 570**

**Navy Technical Disclosure Bulletin, vol. 12, no. 4, June 1986, (Arlington, US); G.D. Kassotakis: "High power VLSI packaging technique", pages 85-89.**
**Patent Abstracts of Japan, vol. 7, no. 158 (E-186) (1303) 12 July 1983 & JP A 58-66344**

(73) Proprietor: **Unisys Corporation**
**P.O. Box 500**
**Blue Bell Pennsylvania 19424 (US)**

(72) Inventor: **TUSTANIWSKYJ, Jerry, Ihor**
**26822 Avenue Domingo**
**Mission Viejo, CA 92691 (US)**

(74) Representative: **Eisenführ, Speiser & Strasse**
**Martinistrasse 24**
**D-2800 Bremen 1 (DE)**

Courier Press, Leamington Spa, England.

## Description

This invention relates to integrated circuit packages; and more particularly, it relates to multichip packages which have a small footprint (attachment area) and provide thermal paths for cooling both high-power and low-power integrated circuits.

Initially in the past, integrated circuit chips were packaged separately. Such single-chip packages encapsulated a chip to protect it from contamination, and to provide input/output terminals by which the chip could be soldered into a printed circuit board. Typically, the packages were made of plastic or ceramic.

Subsequently, multichip integrated packages were developed which encapsulated several chips. One attractive feature of multichip packages is that they provide low capacitance interconnections between the chips within the package, and thus the delay of inter chip signal propagation is reduced. Usually, the number of chips which are encapsulated in a multichip package is between two and twenty.

A problem, however, which is aggravated by multichip packages is how to keep the package from overheating. This is because all of the chips in a packag dissipate power which cause the package to heat up. To resolve such a heat-dissipation problem, it is very desirable to not comprise the size of the package's footprint. A package's footprint (attachment area) is the area which it occupies on a printed circuit board, and it should be kept as small as possible so that more packages can be placed on the board.

In the past, a cavity-down multichip package was often used whenever some of the chips to be packaged had a high power dissipation. Such a package is comprised of a thin body having top and bottom major surfaces; chips are held in downward-facing cavities which extend from the bottom surface into the body; and input/output pins are disposed in rows on the periphery of the bottom surface around the cavities. This package will cool the high power dissipating chips because it provides a small thermal resistance path from the downward-facing cavity to the top surface.

However, it has been determined by the present inventor that the cavity-down package is very inadequate for handling the frequent situation where some but not all of the chips have a high power dissipation. Specifically, in such a case, the present inventor has found that the footprint of the package can be reduced by over 100% without compromising the cooling for the high power chips.

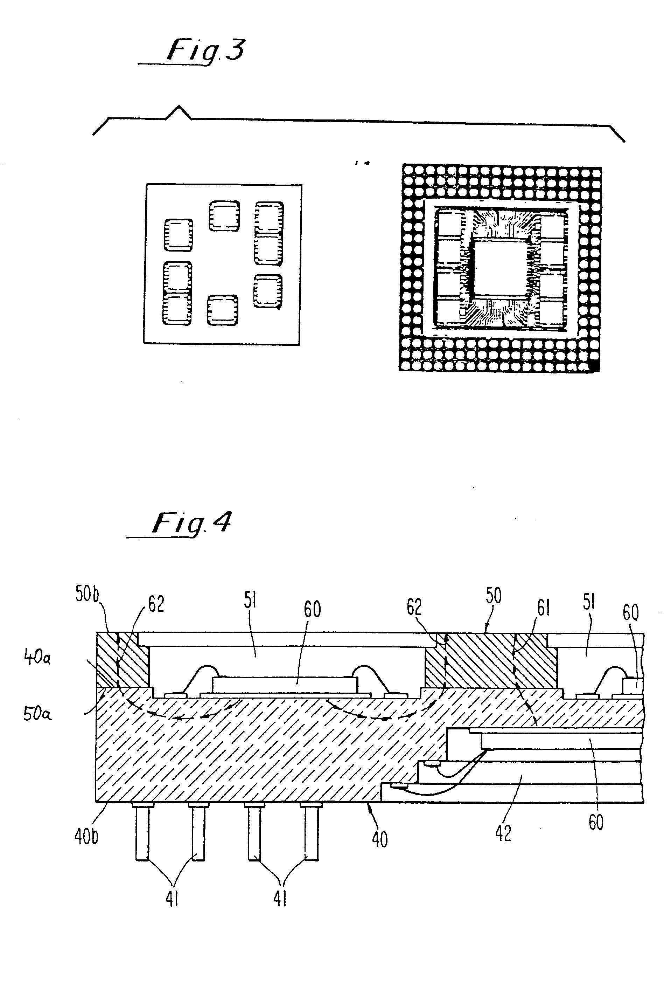

From the publication Navy Technical Disclosure Bulletin Vol. 11, NO. 4, June 1986, Arlington, Va, USA, pages 85 to 89, high power VLSI packaging techniques are known wherein Figure 4 shows a technique using a molybdenum heat sink layer provided between two printed circuit boards and carrying two chip devices, each mounted on one side directly to the molybdenum heat sink.

According to the invention, a cavity-up-cavity-down integrated circuit package is provided comprising the features as defined in claim 1. Preferable embodiments are defined in the dependent claims.

Various embodiments are described in the Detailed Description in conjunction with the accompanied drawings wherein:

Fig. 1 is a top view of one embodiment;

Fig. 2 is an enlarged sectional view taken along lines 2—2 in Fig. 1;

Fig. 3 compares an actual package that is constructed according to Figs. 1 and 2 to a prior art cavity down package; and

Fig. 4 is an enlarged sectional view of another embodiment.

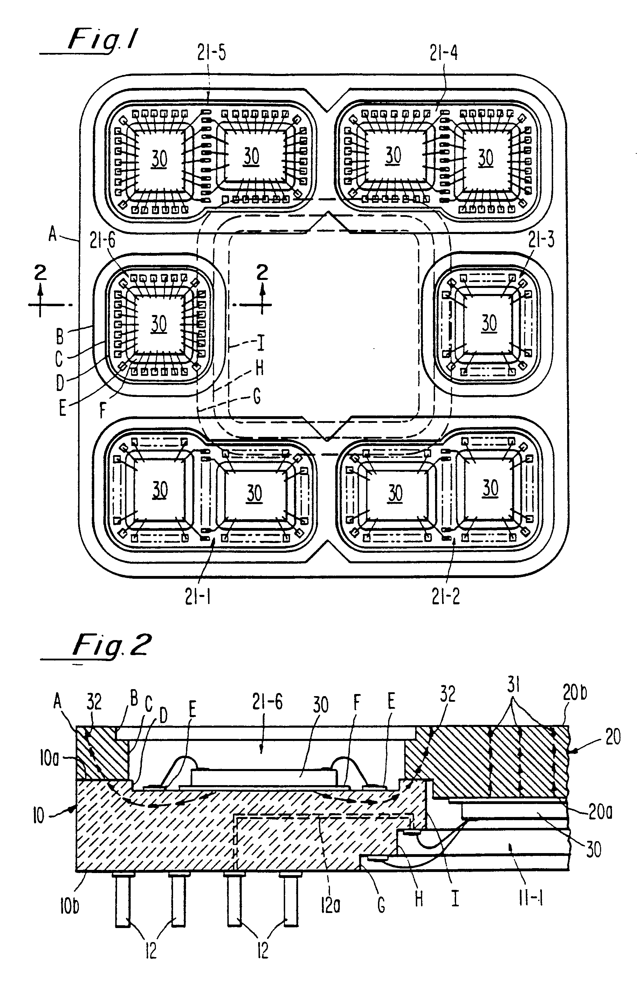

Referring now to Figs. 1 and 2, a preferred embodiment of an integrated circuit package will be described in detail. This embodiment is comprised of two thin planar members 10 and 20 which are respectively made of alumina ceramic and copper tungsten. Member 10 has major surfaces 10a and 10b, and member 20 has major surfaces 20a and 20b. One aperture 11-1 passes through surfaces 10a and 10b of member 10 at its center; and six apertures 21-1 through 21-6 pass through surfaces 20a and 20b of member 20 around its periphery.

Surfaces 10a and 20a are permanently joined together by brazing or by an epoxy. Surface 10a blocks all of the apertures 21-1 through 21-6 in member 20, and surface 20a blocks aperture 11-1 in member 10. As a result, oppositely facing cavities are formed for holding integrated circuit chips 30. Letters A through I in Figs. 1 and 2 identify corresponding points in these cavities. Letter F indicates a pad for attaching the chips in the cavity; letter E indicates a pad for bonding a signal-carrying wire to the chip, and all of the other letters simply indicate various edges. Thin flat lids (not shown) can be attached to the surfaces 10b and 20b to cover the cavities.

Input/output pins (I/O pins) 12 extend from surface 10b in a direction which is herein referred to as downward. That cavity which is formed by aperture 11-1 is also facing downward. By comparison, the cavities which are formed by apertures 21-1 through 21-6 are facing upward. All of the I/O pins 12 are arranged in four rows which go around the periphery of surface 10b. Conductors, only one of which is shown as 12a, are integrated into member 10 and connect the pins 12 to the wire bond pads.

These I/O pins 12 lie beneath the apertures 21-1 through 21-6 in member 20; and due to this arrangement, the footprint of the disclosed package is substantially reduced in comparison to the footprint of a conventional cavity-down package. High power integrated circuit chips are held in the downward-facing cavity since heat is conducted from them along a low thermal resistance path 31 to a heat sink (not shown) on surface 20b. Low power integrated circuit chips are held in the upward-facing cavities, and heat is conducted from them along a higher thermal resistance path 32.

When member 10 is made of alumina ceramic and member 20 is made of copper tungsten, and surface 20b is air cooled, the thermal resistance of paths 31 and 32 respectively are about 4° C/watt and 20° C/watt. With those same materials and surface 20b being liquid cooled, the thermal resistance of paths 31 and 32 respectively are about 1/2° C/watt and 6° C/watt. Thus, in the latter case for example, chip 30 in the downward-facing cavity could dissipate 15 watts; each chip in the upward-facing cavity could dissipate 1-1/4 watts; and the temperature of every chip would only be 7-1/2° C above the temperature of the coolant.

Preferably, in the above cases, chips for the upward-facing cavities dissipate less than 2 watts. Such chips include bipolar static RAM chips, small scale integration logic chips, and CMOS dynamic RAMs. Also, preferably, chips for the downward-facing cavities dissipate more than 2 watts. Such chips include custom large scale bipolar chips, semicustom ECL gate arrays, and microcomputer chips.

A numerical example which illustrates the degree to which the footprint is reduced by the above described integrated circuit package is given as follows:

If cavities 21-3 and 21-6 are each one-quarter-inch on a side, and the cavity 11-1 is one-half-inch on a side, the width of the disclosed package would be about 1/4"+1/2"+1/4" or one inch; and consequently its footprint would be about one square inch. (1"=2,54 cm).

A reasonable width of four rows of I/O pins 12 is about three-eighths of an inch. Thus, the width of a conventional cavity-down package which has cavities as given by equation 1 would be 3/8"+1/4"+1/2"+1/4"+3/8" or one and three-quarters inches. Such a cavity-down package would have a footprint of 3.06 square inches. Thus, the percent area saved by the disclosed integrated circuit package is more than 200%!

Figure 3 compares an actual package that is constructed according to Figs. 1 and 2 to the prior art cavity-down package. Both of these packages hold eight small low power chips, and one large high power chip. In the disclosed package, which is on the left, the eight small low power chips are positioned around the periphery of the top surface; the input/output pins are positioned below those eight chips on the bottom surface; and the one large high power chip is centrally located on the bottom surface. By comparison, in the prior art cavity-down package which is shown on the right, all of the high power and low power chips as well as the I/O pins are located on the bottom surface. Consequently, the footprint of the package on the right is more than 100% larger than the footprint of the package on the left.

Turning now to Fig. 4, another embodiment of the invention will be described. This embodiment is comprised of a planar member 40 which has major surfaces 40a and 40b, and another planar member 50 which has major surfaces 50a and 50b. Input/output pins 41 extend in a downward direction from the periphery of surface 40b, and one or more downward-facing cavities 42 also extend from that surface partway through member 40. In other words, member 40 differs from the previously described member 10 of Figs. 1 and 2 in that no apertures completely penetrate member 40.

By comparison, member 50 does contain apertures 51 which penetrate its major surfaces. Also, surface 50a is permanently joined to surface 40a, and surface 40a blocks the apertures 51. Thus upward-facing cavities are formed for holding respective integrated chips 60. Some of these upward-facing cavities in member 50 partially overlie the downward-facing cavities 42 in member 40. Consequently, the number of chips which the Fig. 4 embodiment holds for a given footprint size is increased over the previously described embodiment.

Heat is conducted from the chips 60 in the downward-facing cavities 42 along a thermal path 61, and heat is conducted from the chips 60 in the upward-facing cavities along a thermal path 62. By always providing a solid portion of member 50 directly over each downward-facing cavity 42, path 61 will have a lower thermal resistance than path 62. For example, when member 40 is made of ceramic and member 50 is made of copper tungsten and surface 52b is liquid cooled, the thermal resistances 61 and 62 respectively are about 2° C/watt and 6° C/watt.

Various embodiments have now been described in detail. In addition, however, modifications comprised within the scope of the claims can be made to these details. For example, the top member 20 in the Fig. 2 embodiment as well as the top member 40 in the Fig. 4 embodiment can be constructed of metals other than copper tungsten such as copper-molybdenum-copper, and they can also be constructed of ceramic. Further, if members 10 and 20, or members 40 and 50, are both made of ceramic, then they can be co-fired together as a single integrated body. Also, the input/output pins of the Fig. 2 and Fig. 4 embodiments can be replaced with other terminals such as those which are suitable for surface mounting.

**Claims**

1. A cavity-up-cavity-down integrated circuit package, comprising:
   top and bottom thin planar members (20, 10); each of said thin planar members having an upward-facing major surface (20b, 10a) and a downward-facing major surface (20a, 10b), and having at least one aperture (21-1 ... 21-6, 11-1) which penetrates both of its major surfaces;
   said downward-facing major surface (20a) of said top planar member (20) being permanently joined by an adhesive material directly to said upward-facing major surface (10a) of said bottom planar member (10);
   input/output terminals (12) at the downward facing surface (10b) of the bottom member (10) formed below and aligned with said apertures (21-1 ... 21-6) in said top member (20); each aperture (21-1 ... 21-6) in said top planar member (20) being located such that it is blocked by said upward-facing major surface (10a) of said bottom planar member (10), and each aperture (11-1) in said bottom planar member (10) being located such that it is blocked by said downward-facing surface (20a) of said top planar member (20);

a low power integrated circuit chip (30) on said upward-facing surface (10a) of said bottom member (10) within each aperture (21-1 ... 21-6) of said top member (20), and a high power integrated circuit chip (30) on said downward-facing surface (20a) of said top member (20) within each aperture (11-1) of said bottom member (10); and

conductors (12a), integrated into said bottom member (10) but not said top member, for carrying electrical signals from said downward-facing surface (10b) of said bottom member (10) to all of said chips; whereby

a) each high power chip (30) has a thermal conduction path (31) which goes directly through said thin top planar member (20);

b) each low power chip (30) has a thermal conduction path (32) which goes from said bottom planar member (10) through said adhesive material directly to said top planar member (20);

c) every chip (30) has short signal paths (12a) that go through just said bottom member (10); and

d) said package has a small attachment area due to the alignment of said terminals (12) with said apertures in said top member.

2. An integrated circuit package according to claim 1, wherein said downward-facing surface (20a) of said top planer member (20) is directly joined to said upward-facing surface (10a) of said bottom planar member (10) by either an epoxy or a braze.

3. An integrated circuit package according to claims 1 or 2, wherein said top planar member (20) and said bottom planar member (10) have respective perimeters that coincide with one another.

4. An integrated circuit package according to any of claims 1—3, wherein said bottom planar member (10) has just one aperture (11-1), and wherein input/output terminals (12) are located on said downward-facing surface (10b) of said bottom member (10) as an array around said one aperture (11-1).

5. An integrated circuit package according to any of claims 1—4,

wherein said top planar member (20) has multiple apertures (21-1 ... 21-6) which overlie and are aligned with said input/output terminals (12).

6. An integrated circuit package according to any of claims 1—5,

wherein said high power integrated circuit (30) chip dissipates at least two watts, and each low power integrated circuit chip (30) dissipates less than two watts.

7. An integrated circuit package according to any of claims 1—6,

wherein said top planar member (20) is made of a material having a substantially higher thermal conductivity than said bottom planar member (10).

8. A cavity-up-cavity-down integrated circuit package, comprising:

a thin planar body (40, 50) having a top major surface (50b) and a bottom major surface (40b);

downward-facing cavity (42) which extends from said bottom surface (40b) to just partway through said body;

an upward-facing cavity (51) which extends from said top surface (50b) to just partway through said body; a low power integrated circuit chip (60) in said upward-facing cavity (51), and a high power integrated circuit chip (60) in said downward-facing cavity (42); and

conductors, integrated into said body, for carrying electrical signals to all of said chips (60) including input/output terminals (41) on a portion of said bottom major surface (40b) below said upward facing cavity (51), whereby

said high power chip (60) in said downward-facing cavity (42) has a thermal conduction path (61) which goes directly through said body (40, 50) to said top surface (50b), said low power chip (60) on said upward-facing cavity (51) has a thermal conduction path (62) which goes through said body (40, 50) around said upward-facing cavity (51) to said top surface (50b), and the package attachment area is minimized by the location of said terminals (41) below said upward facing cavity (51).

9. An integrated circuit package according to claim 8, wherein said body consists of cofired layers (40, 50) of ceramic.

10. An integrated circuit package according to claim 8 or 9, wherein said bottom surface (40b) has just one cavity (42), and wherein the input/output terminals (41) are located on said bottom surface (40b) as an array around said one cavity (42).

11. An integrated circuit package according to any of claims 8—10, wherein said top surface (50b) has multiple cavities (51) which overlie and are aligned with said input/output terminals (41).

12. An integrated cicuit package according to any of claims 8—11, wherein said high power integrated circuit (60) chip dissipates at least two watts, and said low power integrated circuit chip (60) dissipates less than two watts.

**Patentansprüche**

1. Integrierte Schaltungspackung mit nach oben und nach unten gerichteten Vertiefungen, mit:

oberen und unteren dünnen ebenen Elementen (20, 10), von denen jedes dünne ebene Element eine nach oben gerichtete Hauptfläche (20b, 10a) und eine nach unten gerichteten Hauptfläche (20a, 10b) und mindestens eine Öffnung (21-1 ... , 21-6, 11-1) besitzt, welche beide Hauptflächen durchdringt;

wobei die nach unten gerichtete Hauptfläche (20a) des oberen ebenen Elementes (20 dauerhaft durch Klebstoff direkt mit der nach oben gerichteten Hauptfläche (10a) des unteren ebenen Elementes (10) verbunden ist;

wobei Eingangs-/Ausgangskontakte (12) an der nach unten gerichteten Fläche (10b) des unteren Elementes (10) nach unten ausgebildet und zu den Öffnungen (21-1, ... 21-6) im oberen Element (20) ausgerichtet sind;

wobei jede Öffnung (21-1, ... 21-6) im oberen ebenen Element (20) so angeordnet ist, daß sie von der nach oben gerichteten Hauptfläche (10a) des unteren ebenen Elementes (10) gesperrt wird, und jede Öffnung (11-1) im unteren ebenen Element (10) so angeordnet ist, daß sie von der nach unten gerichteten Fläche (20a) des oberen ebenen Elementes (20) gesperrt wird;

einem integrierten Niederspannungsschaltkreis-Chip (30) an der nach oben gerichteten Fläche (10a) des unteren Elementes (10) innerhalb jeder Öffnung (21-1 ... 21-6) des oberen Elementes (20) und einem integrierten Hochspannungsschaltkreis-Chip (30) an der nach unten gerichteten Fläche (20a) des oberen Elementes (20) innerhalb jeder Öffnung (11-1) des unteren Elementes (10); und

Stromleitern (12a), die in das untere Element (10), jedoch nicht in das obere Element integriert sind, um elektrische Signale von der nach unten gerichteten Fläche (10b) des unteren Elementes (10) zu sämtlichen Chips zu übertragen; wobei

a) jeder Hochspannungs-Chip (30) einen Wärmeleitweg hat, der direkt durch das dünne obere ebene Element (20) verläuft;

b) jeder Niederspannungs-Chip (30) einen Wärmeleitweg (32) hat, der vom unteren ebenen Element (10) durch den Klebstoff direkt zum oberen ebenen Element (20) verläuft;

c) jeder Chip (30) kurze Signalwege (10a) hat, die genau durch das untere Element (10) verlaufen; und

d) die Packung eine kleine Befestigungsflache aufgrund der Ausrichtung der Kontakte (12) zu den Öffnungen im oberen Element besitzt.

2. Integrierte Schaltungspackung nach Anspruch 1, bei welcher die nach unten gerichtete Fläche (20a) des oberen ebenen Elementes (20) direkt mit der nach oben gerichteten Fläche (10a) des unteren ebenen Elementes (10) durch entweder Epoxid oder Lötlot verbunden ist.

3. Integrierte Schaltungspackung nach den Ansprüchen 1 oder 2, bei welcher das obere ebene Element (20) und das untere ebene Element (10) entsprechende Umfangsabmessungen besitzen, die miteinander übereinstimmen.

4. Integrierte Schaltungspackung nach einem der Ansprüche 1 bis 3, bei welcher das untere ebene Element (10) gerade eine Öffnung (10-1) besitzt und bei welcher die Eingangs-/Ausgangskontakte (12) an der nach unten gerichteten Fläche (10b) des unteren Elementes (10) als Feld um diese eine Öffnung (11-1) herum angeordnet sind.

5. Integrierte Schaltungspackung nach einem der Ansprüche 1 bis 4, bei welcher das obere ebene Element (20) mehrere Öffnungen (21-1, ... , 21-6) besitzt, die über den Eingangs-/Ausgangskontakten (12) liegen und zu diesen ausgerichtet sind.

6. Integrierte Schaltungspackung nach einem der Ansprüche 1 bis 5, bei welcher der integrierte Hochspannungsschaltkreis-Chip (30) mindestens zwei Watt verbraucht und jeder integrierte Niederspannungsschaltkreis-Chip (30) weniger als 2 Watt verbraucht.

7. Integrierte Schaltungspackung nach einem der Ansprüche 1 bis 6, bei welcher das obere ebene Element (20) aus einem Material mit einer im wesentlichen höheren Wärmeleitfähigkeit als das untere ebene Element (10) hergestellt ist.

8. Integrierte Schaltungspackung mit nach oben und nach unten gerichteten Vertiefungen, mit:

einen dünnen ebenen Körper (40, 50) mit einer oberen Hauptfläche (50b) und einer unteren Hauptfläche (40b); einer nach unten gerichteten Vertiefung (42), die sich von der unteren Fläche (40b) genau teilweise durch den Körper erstreckt;

einer nach oben gerichteten Vertiefung (51), die sich von der oberen Fläche (50b) genau teilweise durch den Körper erstreckt;

einem integrierten Niederspannungsschaltkreis-Chip (60) in der nach oben gerichteten Vertiefung (51) und einem integrierten Hochspannungsschaltkreis-Chip (60) in der nach unten gerichteten Vertiefung (42); und

in den Körper integrierten Stromleitern, um elektrische Signale an sämtliche Chips (60) zum übertragen, die Eingangs-/Ausgangskontakte (41) an einem Abschnitt der unteren Hauptfläche (40b) unterhalb der nach oben gerichteten Vertiefung (51) aufweisen, wobei der Hochspannungs-Chip (60) in der nach unten gerichteten Vertiefung (42) einen Wärmeleitweg (61) hat, der direkt durch den Körper (40, 50) zu der oberen Fläche (50b) verläuft, der Niederspannungs-Chip (60) in der nach oben gerichteten Vertiefung (51) einen Wärmeleitweg (62) hat, der durch den Körper (40, 50) um die nach oben gerichtete Vertiefung (51) herum zu der oberen Fläche (50b) verläuft und die Packungsbefestigungsfläche durch Anordnung der Kontakte (41) um die nach unten gerichtete Vertiefung (51) minimiert ist.

9. Integrierte Schaltungspackung nach Anspruch 8, bei welcher der Körper aus zusammengebrannten Keramikschichten (40, 50) besteht.

10. Integrierte Schaltungspackung nach Anspruch 8 oder 9, bei welcher die untere Fläche (40b) gerade eine Vertiefung (42) besitzt und die Eingangs-/Ausgangskontakte (41) an der unteren Fläche (40b) als ein Feld um die eine Vertiefung (42) herum angeordnet sind.

11. Integrierte Schaltungspackung nach einem der Ansprüche 8 bis 10, bei welcher die obere Fläche (50b) mehrere Vertiefungen (51) besitzt, die über den Eingangs-/Ausgangskontakten (41) liegen und zu diesen ausgerichtet sind.

12. Integrierte Schaltungspackung nach einem der Ansprüche 8 bis 11, bei welcher der integrierte Hochspannungsschaltkreise-Chip (60) mindestens 2 Watt verbraucht und der integrierte Niederspannungsschaltkreise-Chip (60) weniger als 2 Watt verbraucht.

**Revendications**

1. Boîtier pour circuit intégré à cavités ouvertes vers le haut et cavités ouvertes vers le bas, comportant:

— des éléments plans, minces, supérieurs et inférieurs (20, 10); chacun de ces éléments plans, minces, ayant une surface principale tournée vers le haut (20b, 10a) et une surface principale tournée vers le bas (20a, 10b) ainsi qu'au moins une ouverture (21-1 ... 21-6, 11-1) qui traverse ses deux surfaces principales;

la surface principale tournée vers le bas (20a) de l'élément plan supérieur (20) étant réunie en permanence par une matière adhésive, directement à la surface principale tournée vers le haut (10a) de l'élément plan inférieur (10),

— des bornes entrée/sortie (12) de la surface tournée vers le bas (10b) de l'élément inférieur (10) formées sous les ouvertures (21-1 ... 21-6) et alignées avec celles-ci dans l'élément supérieur (20), chaque ouverture (21-1 ... 21-6) de l'élément plan supérieur (20) étant positionnée pour être bloquée par la surface principale tournée vers le haut (10a) de l'élément plan inférieur (10) et chaque ouverture (11-1) de l'élément plan inférieur (10) est positionnée pour être bloquée par la surface tournée vers le bas (20a) de l'élément plan supérieur (20);

— une plaque de circuit intégré de faible puissance (30) sur la surface tournée vers le haut (10a) de l'élément inférieur (10) à l'inférieur (10) à l'intérieur de chaque ouverture (21-1 ... 21-6) de l'élément supérieur (20) et une plaquette de circuit intégré de forte puissance (30) de la surface tournée vers le bas (20a) de l'élément supérieur (20) à l'intérieur de chaque ouverture (11-1) de l'élément inférieur (10); et

— des conducteurs (12a) intégrés à l'élément inférieur (10) mais non à l'élément supérieur pour le passage de signaux électriques de la surface tournée vers le bas (10b) de l'élément inférieur (10) vers toutes les plaquettes, et

a) chaque plaquette de forte puissance (30) présente un chemin de conduction thermique (31) allant directement à travers l'élément plan supérieur mince (20),

b) chaque plaquette de faible puissance (30) présente un chemin de conduction thermique (32) qui va de l'élément plan inférieur (10) à travers la matière adhésive, pour rejoindre directement l'élément plan supérieur (20);

c) chaque plaquette (30) présente des chemins de signaux courts (12a) qui traversent directement l'élément inférieur (10) et

d) chaque boîtier présente une faible surface de fixation du fait de l'alignement des bornes (12) avec les petites ouvertures de l'élément supérieur.

2. Boîtier de circuit intégré selon la revendication 1, caractérisé en ce que la surface tournée vers le bas (20a) de l'élément plan supérieur (20) est réuni directement à la surface tournée vers le haut (10a) de l'élément plan inférieur (10) soit par une résine époxy, soit par une brasure.

3. Boîtier de circuit intégré selon la revendication 1 ou 2, caractérisé en ce que l'élément plan supérieur (20) et l'élément plan inférieur (10) ont des périmètres respectifs qui coïncident.

4. Boîtier de circuit intégré selon l'une quelconque des revendications 1—3, caractérisé en ce que l'élément plan inférieur (10) présente juste une ouverture (11-1) et les bornes entrée/sortie (12) se trouvent sur la surface tournée vers le bas (10b) de l'élément inférieur (10) sous la forme d'un arrangement autour d'une ouverture (11-1).

5. Boîtier de circuit intégré selon l'une quelconque des revendications 1—4, caractérisé en ce que l'élément plan supérieur (20) présente de multiples ouvertures (21-1 ... 21-6) qui recouvrent les bornes entrée/sortie (12) et sont alignées sur celles-ci.

6. Boîtier de circuit intégré selon l'une quelconque des revendications 1—5, caractérisé en ce que la plaquette de circuit intégré de forte puissance (30) dissipe au moins deux wattes et chaque plaquette de circuit intégré de faible puissance (20) dissipe moins de deux watts.

7. Boîtier de circuit intégré selon l'une quelconque des revendications 1—6, caractérisé en ce que l'élément plan supérieur (20) est réalisé en un matériau ayant une conductivité thermique notablement supérieure à celle de l'élément plan inférieur (10).

8. Boîtier de circuit intégré à cavités tournées vers le haut et cavités tournées vers le bas, comprenant:

— un corps plan mince (40, 50) ayant une surface supérieure principale (50b) et une surface inférieure principale (40b),

— une cavité tournée vers la bas (42) qui part de la surface inférieure (40b) pour arriver en partie à travers le corps,

— une cavité tournée vers le haut (51) qui part de la surface supérieure (50b) pour arriver partiellement dans le corps,

— une plaquette de circuit intégré de faible puissance (60) réalisée dans la cavité tournée vers le haut (51) et une plaquette de circuit intégré de forte puissance (60) réalisée dans la cavité tournée vers le bas (42) et

— des conducteurs intégrés au corps pour le transfert des signaux électriques vers toutes les plaquettes (60) comprenant des bornes entrée/sortie (41) sur une partie de la surface inférieure principale (40b) en-dessous de la cavité principale (51) tournée vers le haut, et

— la plaquette de forte puissance (60) de la cavité (42) tournée vers le bas présente un chemin de conduction thermique (61) qui est relié directement à travers le corps (40, 50) à la surface supérieure (50b), la plaquette de faible puissance (60) de la cavité tournée vers le haut (51) ayant un chemin de conduction thermique (62) qui traverse le corps (40, 50) autour de la cavité (51) tournée vers le haut jusqu'à la surface supérieure (50b) et la surface de fixation du boîtier est réduite au minimum par le positionnement des bornes (41) en dessous de la cavité (51) tournée vers le haut.

9. Boîtier de circuit intégré selon la revendiction 8, caractérisé en ce que le corps se composé de couches (40, 50) de matière céramique, cuites ensemble.

10. Boîtier de circuit intégré selon la revendication 8 ou 9, caractérisé en ce que la surface inférieure (40b) présente seulement une cavité (42) et les bornes entrée/sortie (41) se trouvent dans la surface inférieure (40b) sous la forme d'un réseau entourant une cavité (42).

11. Boîtier de circuit intégré selon l'une des revendications 8 à 10, caractérisé en ce que la surface supérieure (50b) présente de multiples cavités (51) qui recouvrent les bornes entrée/sortie (41) et sont alignées sur celles-ci.

12. Boîtier de circuit intégré selon l'une quelconque des revendications 8 à 11, caractérisé en ce que la plaquette de circuit intégré de forte puissance (60) dissipe au moins deux watts et la plaquette de circuit intégré (60) de faible puissance dissipe moins de deux watts

Fig.1

Fig.2

EP 0 311 674 B1

_Fig.3_

_Fig.4_